# EUROPÄISCHE PATENTSCHRIFT

(11) **EP 1 584 708 B1**
(45) Veröffentlichungstag und Bekanntmachung des Hinweises auf die Patenterteilung: **04.01.2017**
(21) Anmeldenummer: 05007718.9
(22) Anmeldetag: 08.04.2005
(51) Int. Cl.: C23C 18/16, H05K 3/00, C23G 1/00

(54) **Verfahren zur Behandlung von laserstrukturierten Kunststoffoberflächen**
Process for the treatment of laser-structured plastic surfaces
Procédé pour le traitement de surfaces en matière plastique structurées au laser

(30) Priorität: 08.04.2004 DE 102004017440
(43) Veröffentlichungstag der Anmeldung: 12.10.2005
(73) Patentinhaber: Enthone Inc., West Haven, Connecticut 06516 (US)
(72) Erfinder: Schildmann, Mark Peter, 42697 Solingen (DE)
(74) Vertreter: Michalski Hüttermann & Partner Patentanwälte mbB

(56) Entgegenhaltungen:
- EP-A- 0 377 867
- EP-A- 1 364 984
- EP-A- 1 389 746
- WO-A-03/005784
- WO-A1-99/05895
- DE-A1- 10 110 823
- DE-A1- 19 851 101
- GB-A- 1 573 207
- US-A- 4 440 801
- US-A- 5 084 299
- US-A- 5 211 803
- US-A1- 2001 040 047
- US-A1- 2002 077 259
- US-A1- 2003 129 371
- US-B1- 6 319 564
- FELDMANN K ET AL: "EXCIMERLASERSTRUKTURIERUNG UND ADDITIVE METALLISIERUNG VON THERMOPLASTEN" F & M FEINWERKTECHNIK MIKROTECHNIK MIKROELEKTRONIK, HANSER, MUNCHEN, DE, Bd. 106, Nr. 3, März 1998 (1998-03), Seiten 150-154, XP000773997 ISSN: 1437-9503
- DATABASE INSPEC [Online] THE INSTITUTION OF ELECTRICAL ENGINEERS, STEVENAGE, GB; Mai 2002 (2002-05), "Laser-activateable plastics and laser devices that deliver flexible 3D MID technology" XP008065589 Database accession no. 7344452 & Microwave Journal, Euro-Global Edition Horizon House Publications USA, Bd. 45, Nr. 5, Mai 2002 (2002-05), Seiten 329-332, ISSN: 0192-6225
- DATABASE INSPEC [Online] THE INSTITUTION OF ELECTRICAL ENGINEERS, STEVENAGE, GB; 1998, ESSER G ET AL: "Laser assisted techniques for patterning of conductive tracks on molded interconnect devices" XP008065584 Database accession no. 6020515 & PROCEEDINGS OF PAN PACIFIC MICROELECTRONICS SYMPOSIUM 10-13 FEB. 1998 KONA, HI, USA, 1998, Seiten 225-233, Pan Pacific Microelectronics Symposium. Proceedings of the Technical Program Surface Mount Technol. Assoc Edina, MN, USA
- DATABASE INSPEC [Online] THE INSTITUTION OF ELECTRICAL ENGINEERS, STEVENAGE, GB; 1998, BEITINGER G ET AL: "UV (248 nm)-laser structuring and additive metallization versus subtractive Nd:YAG-laser structuring [PCB/MID fabrication]" XP008065582 Database accession no. 6363941 & PROCEEDINGS OF IPC/SMTA ELECTRONICS ASSEMBLY EXPO 24-29 OCT. 1998 PROVIDENCE, RI, USA, 1998, Seiten S20ba-h, IPC/SMTA Electronics Assembly Expo. Proceedings of the Technical Program Surface Mount Technol. Assoc Edina, MN, USA
- HÜSKE M ET AL: "Laser supported activation and additive metallization of thermoplastics for 3D-MIDS" PROCEEDINGS OF THE 3RD LANE, 28. März 2001 (2001-03-28), Seiten 1-12, XP002242586

## Beschreibung

Die vorliegende Erfindung betrifft ein Verfahren zur Behandlung von mittels Laser zur Erzeugung von zur anschließenden Metallisierung geeigneten Keimstrukturen auf der Oberfläche strukturierten Kunststoffsubstraten.

Spritzgegossene Schaltungsträger, sogenannte moulded interconnected devices (MID), werden heute in vielfältiger Weise in der Elektronikindustrie eingesetzt. Solche Schaltungsträger werden dreidimensional (3D-MID) ausgebildet.

Ziel der 3D-MID-Technologie ist es, elektrische und mechanische Funktionen in einem Bauteil zu vereinen. Die Leiterbahnen werden hierbei in das Gehäuse integriert und substituieren so die konventionellen Leiterplatten. Gewicht und Einbauraum können effektiv reduziert werden, die Integration von Sensoren und dergleichen ist vereinfacht.

Es gibt unterschiedliche Technologien zur Herstellung von 3D-MIDs. Zu diesen Technologien gehören das Zweikomponentenspritzgießen, das Heißprägen, das Folienhinterspritzen und die additive oder subtraktive Laserstrukturierung.

Die deutsche Patentanmeldung DE 10132092 sowie die europäische Patentanmeldung EP 1 274 288 offenbaren Verfahren zur Laserstrukturierung von Leiterbahnen. Bei diesem Verfahren werden Leiterbahnstrukturen auf einem elektrisch nicht leitenden Trägermaterial erzeugt, die aus Metallkeimen und einer nachfolgenden auf diese aufgebrachten Metallisierung bestehen, wobei die Metallkeime durch Aufbrechen von feinstverteilt in dem Trägermaterial enthaltenen elektrisch nicht leitenden Metallverbindungen durch elektromagnetische Strahlung entstanden sind. Hierbei sind die elektrisch nicht leitenden Metallverbindungen von thermisch hochstabilen, in wässrigen sauren oder alkalischen Metallisierungsbädem beständigen und nicht löslichen anorganischen Metallverbindungen gebildet, die in nicht laserbestrahlten Bereichen unverändert bleiben. Die eingesetzten anorganischen Metallverbindungen sind derart temperaturbeständig, daß sie nach Einwirkung der Löttemperatur stabil bleiben. Die Leiterbahnen sind sicher und einfach herzustellen und es wird eine sehr hohe Haftfestigkeit erzielt.

Auch in der WO 03/005784 wird ein Verfahren zur Laserstrukturierung von Leiterbahnen beschrieben. Dabei erfolgt vor dem Aufbau der Leiterbahnen, in einem chemisch reduktiven Verkupferungsbad, eine Reinigung in einem Ultraschall-Reinigungsbad.

Das Dokument US 2002/077259 offenbart auch ein Verfahren fur Herstellung der Leiterbahustrukturen auf einem Kunststoffsubstrat, wobei nach der Laserstrukturierung und vor der Metallisierung das laserstrukchrierte Kunststoffsubstrat in einer sauren Lösung-3Gew, H₂SO₄-eingetaucht wird, so dass das kuper selekchir auf denleitbahn-strukturen stattfindet.

Ein Problem dieser Verfahren besteht jedoch darin, daß bei der Laserstrukturierung Teile der Substratoberfläche, und somit auch Metallkeime aufgrund der Temperaturentwicklung entfernt und/oder zersetzt werden, wobei sich diese an anderen Stellen auf der Substratoberfläche niederschlagen können.

Bei einer anschließenden Metallisierung der erzeugten Leiterbahnstrukturen werden nicht nur die Leiterbahnstrukturen, sondern auch die ungewollt abgelagerten Metallkeime metallisiert.

Diese unplanmäßigen Ablagerungen können zu einer Verschlechterung der Selektivität der Leiterbahnstrukturen und somit zu Problemen durch Kurzschlüsse in den elektrischen Bauteilen führen.

Um diese Probleme zu umgehen, können die Abstände zwischen den strukturierten Leiterbahnen so groß gewählt werden, daß sich niedergeschlagene Metallkeime bei der anschließenden Metallisierung keine störenden Einflüsse ausüben. Dieser Lösungsansatz führt jedoch zu mangelhaften Schaltungsdichten und somit zu großen Nachteilen.

Die Aufgabe der Erfindung liegt somit darin, ein Verfahren zur Verfügung zu stellen, mit welchem die ungewollt abgelagerten Metallkeime von der Substratoberfläche vor einer Metallisierung entfernt werden können, ohne die bereits planmäßig strukturierten Leiterbahnen nachhaltig zu beschädigen.

Gelöst wird diese Aufgabe durch ein Verfahren zur Behandlung von mittels Laser zur Erzeugung von zur anschließenden Metallisierung geeigneten Keimstrukturen auf der Oberfläche strukturierten Kunststoffen gemäß vorliegenden Anspruch 1.

Überraschenderweise hat sich gezeigt, daß die Behandlung der laserstrukturierten Substrate vor der Metallisierung mit einer Mischung aus Netzmitteln und die Reinigung unterstützenden Stoffen zu einer hinreichenden Entfernung der ungewollt abgelagerten Metallkeime führte, ohne die planmäßig strukturierten Leiterbahnen nachhaltig zu beschädigen. Es handelt sich um neutralen, sauren und alkalischen Reinigem enthaltene Substanzmischungen (sogenannte builder).

Vergleichsversuche haben gezeigt, daß sowohl alkalische Substanzen wie z. B. Natriumhydroxid, Natriumcarbonat, Rentanatriumtriphosphat, Tetranatriumdiphosphat, Natriumgluconat, Natriummetasilikat, Natriumhydrogencarbonat, Trinatriumcitrat, Tetranatriumpyrophosphat, Natriumtripolyphosphat und entsprechende Kaliumsalze, als auch sauer reagierende Substanzen wie z. B. Phosphorsäure, Schwefelsäure, Salzsäure, Methansulfonsäure, Citronensäure, Bernsteinsäure, Adipinsäure, Amidoschwefelsäure, Malonsäure, Methansäure, Ethansäure, Propansäure, n-Butansäure, n-Pentansäure, n-Hexansäure, Oxalsäure, Natriumhydrogensulfat, Kaliumhydrogensulfat, Borfluorwasserstoffsäure geeignet sind, die ungewollt abgelagerten Metallkeime von der Oberfläche des Substrates zu lösen. Neutrale geeignete Substanzen sind z. B. Kaliumsulfat, Natriumsulfat usw.

Bevorzugte alkalische Substanzen sind Natriumhydroxid, Kaliumhydroxid, Kaliumphosphat und Natriumphosphat.

Bevorzugte sauer reagierende Substanzen sind Phosphorsäure, Schwefelsäure, Methansulfonsäure und Amidoschwefelsäure.

Unterstützt wird dieser Ablösungsprozeß durch geeignete Netzmittel.

Als geeignete Netzmittel erwiesen sich anionische Netzmittel, kationische Netzmittel, amphotere Netzmittel und nicht-ionische Netzmittel. Diese können beispielsweise eine oder mehrere der im Folgenden aufgezählten Substanzen bzw. ein oder mehrere Vertreter der im Folgenden aufgezählten Substanzgruppen sein:
Olsäureethoxylat, Fettalkoholethoxylat, Alkylphenolethoxylat, saurer Phosphorsäureester, Alkylphenolethersulfat und deren Natrium-Salz, Fettsäurekondensationsprodukt und deren Natrium-Salz, Alkylbenzolsulfonat, Alkanolaminsalz, Alkansulfonat und deren Natrium-Salz, Fettaminethoxylat, Fettalkoholalkoxylat, Propylenoxid-Ethylenoxid-Blockpolymerisat, Ethylenoxid-Propylenoxid-Blockpolymerisat, Dimethylfettalkylbenzylammoniumchlorid, Alkylpolyethylenglycolether, Alkylglucoside, Oxoalkohole, Kokosfettsäurediethanolamid, Ölsäurediethanolamid, Natriumlaurylsulfat, Natriumlaurylsulfosuccinat, lineare Alkylbenzolsulfonsäure, Alkylbenzolsulfonate, Alkansulfonate, Fettalkoholsulfate, Fettalkoholethersulfate, Olefinsulfonate, Estersulfonate, Alkylphosphate, Alkyletherphosphate, Fettalkoholethoxylate, Alkylphenolethoxylate, Fettaminethoxylate, Fettsäureethoxylate, Fettsäureesterethoxylate, sonstige Alkoxylate, Alkanolamide, Zuckertenside, Aminoxide, Fluortenside, Alkalisalze von Fettsäuren.

Bevorzugte Netzmittel sind Alkylpolyglucoside, nicht-ionische Netzmittel auf Basis von Polyoxyethylen und amphotere Netzmittel auf Basis von Polyoxyethylen.

Darüber hinaus ist der Einsatz von Ultraschallfeldern während des Inkontaktbringens der Substrate mit einer aus die Reinigung unterstützenden Stoffen und Netzmitteln bestehenden Prozeßlösung von besonderem Vorteil und führt zu einer Verbesserung des Reinigungsresultates.

Mit dem erfindungsgemäßen Verfahren lassen sich ungewollt bei der Laserstrukturierung abgelagerte Keime wie Kupfer-, Chrom-, Eisen-, Kobalt- oder Nickelkeime entfernen.

Weiterhin wird mit Vorteil vorgeschlagen, durch die aufeinanderfolgende Anwendung von alkalischen Reinigungsprozeßlösungen und sauren Reinigungsprozeßlösungen in beliebiger Reihenfolge die Reinigungsergebnisse zu verbessern. Auch von Vorteil ist die ausschließliche Anwendung neutraler Reinigungsprozeßlösungen.

Erfindungsgemäß werden die zu behandelnden Substrate zwischen ungefähr 0,5 und ungefähr 20 Minuten, bevorzugt zwischen ungefähr 2 und ungefähr 6 Minuten, mit der erfindungsgemäßen Prozeßlösung in Kontakt gebracht.

Die Temperatur, bei welcher die Substrate mit der Prozeßlösung in Kontakt gebracht werden, liegt hierbei erfindungsgemäß zwischen etwa ungefähr 20 und ungefähr 90° C, bevorzugt zwischen ungefähr 50 und ungefähr 80° C.

Bei dem erfindungsgemäßen Verfahren sind die sauer reagierenden Substanzen in der Prozeßlösung in einer Konzentration zwischen 0,1 mol/l und 2,0 mol/l, bevorzugt zwischen ungefähr 0,5 mol/l und ungefähr 1,0 mol/l anwesend.

Die alkalischen Substanzen können in der Prozeßlösung des erfindungsgemäßen Verfahrens in einer Konzentration zwischen 0,1 mol/l und 2,0 mol/l, bevorzugt zwischen ungefähr 0,5 mol/l und ungefähr 1 mol/l anwesend sein.

Die neutralen Substanzen können beim erfindungsgemäßen Verfahren in der Prozeßlösung in einer Konzentration zwischen 0,1 mol/l und 2 mol/l, bevorzugt zwischen ungefähr 0,5 mol/l und ungefähr 1,0 mol/l anwesend sein.

Neben dem bereits erwähnten Kalium- und Natriumsulfat können auch mit Phosphorsäure auf einen pH-Wert zwischen 6,0 und 9,5 neutralisiertes Natriumphosphat oder Kaliumphosphat eingesetzt werden.

Die nachfolgend aufgeführten Beispiele stehen exemplarisch für das erfindungsgemäße Verfahren, welches sich jedoch nicht auf diese beschränken läßt.

### Beispiel 1:

Behandlung eines laserstrukturierten Substrates für 5 Minuten bei einer Temperatur von 80° mit einer Lösung bestehend aus Wasser, Phosphorsäure, einem nicht-ionischen Tensid auf Polyoxyethylenbasis und einem amphoteren Tensid auf Polyoxyethylenbasis.

### Beispiel 2:

Behandlung eines laserstrukturierten Substrates für 5 Minuten bei einer Temperatur von 70° C mit einer Prozeßlösung bestehend aus Wasser, Kaliumhydroxid und einem Alkylpolyglucosid.

### Beispiel 3:

Behandlung eines laserstrukturierten Substrates mit einer Prozeßlösung gemäß Beispiel 1, jedoch unter zusätzlichem Einsatz eines Ultraschallfeldes.

### Beispiel 4:

Behandlung eines laserstrukturierten Substrates mit einer Prozeßlösung gemäß Beispiel 2, jedoch unter zusätzlicher Verwendung eines Ultraschallfeldes.

### Beispiel 5:

Behandlung eines laserstrukturierten Bauteils mit einer neutralen Prozeßlösung durch Eintauchen des Bauteils für 5 Minuten bei einer Temperatur von 80° C in eine Lösung bestehend aus:
30 g/l Na₃PO₄ (mit H₃PO₄ neutralisiert auf einen pH-Wert zwischen 6 und 9,5)
6 ml/l eines Alkylpolyglucosids in Wasser

### Beispiel 6:

Behandlung eines laserstrukturierten Bauteils mit einer neutralen Prozeßlösung unter Verwendung eines Ultraschallfeldes durch Eintauchen des Bauteils für 5 Minuten bei 80° C in eine Lösung,bestehend aus:
30 g/l Na₃PO₄ (mit H₃PO₄ auf einen pH-Wert eingestellt zwischen 6 und 9,5)
6 ml/l eines Alkylpolyglucosids in Wasser

Die Behandlung wurde bei einem Ultraschallfeld mit einer Leistung von 5,6 W/l durchgeführt.

### Beispiel 7:

Aufeinanderfolgende Behandlung eines laserstrukturierten Bauteils mit einer sauren und einer alkalischen Prozeßlösung durch Eintauchen des Bauteils für 3 Minuten bei einer Temperatur von 70° C in eine Lösung,bestehend aus:
0,7 mol/l H₃PO₄
2 g/l eines nicht-ionischen Netzmittels auf Polyoxyethylenbasis
2 g/l eines amphoteren Netzmittels auf Polyoxyethylenbasis in Wasser

Nach einem Spülschritt wurde das Bauteil für 3 Minuten bei 70° C in eine Lösung getaucht bestehend aus
0,9 mol/l KOH
6 ml/l eines nicht-ionischen Netzmittels auf Basis von Alkylpolyglucosiden in Wasser

### Beispiel 8:

Aufeinanderfolgende Behandlung eines laserstrukturierten Bauteils mit einer alkalischen und einer sauren Prozeßlösung durch Eintauchen des Bauteils für 3 Minuten bei 70° C in eine Lösung, bestehend aus
0,9 mol/l KOH
6 ml/l eines nicht-ionischen Netzmittels basierend auf Alkylpolyglucosiden in Wasser

Nach einem Spülschritt wurde das Bauteil für 3 Minuten bei 70° C in eine Lösung getaucht, bestehend aus
0,7 mol/l H₃PO₄
2 g/l eines nicht-ionischen Netzmittels auf Basis von Polyoxyethylen
2 g/l eines amphoteren Netzmittels auf Basis von Polyoxyethylen in Wasser

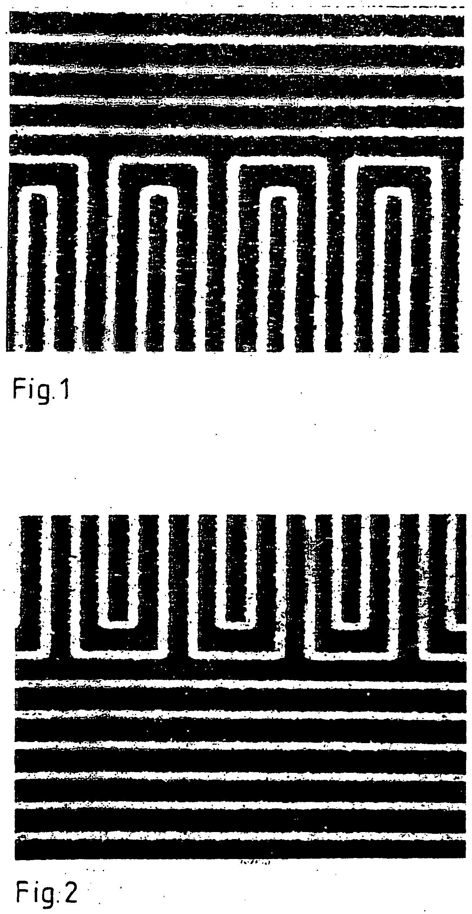

Beschreibung der Figuren
Fig. 1 zeigt eine mikroskopische Aufnahme der Oberfläche eines laserstrukturierten Kunststoffsubstrates ohne erfindungsgemäße Behandlung.
Fig. 2 zeigt die Oberfläche des laserstrukturierten Kunststoffsubstrates nach der Behandlung mit einer Prozeßlösung gemäß Beispiel 1.

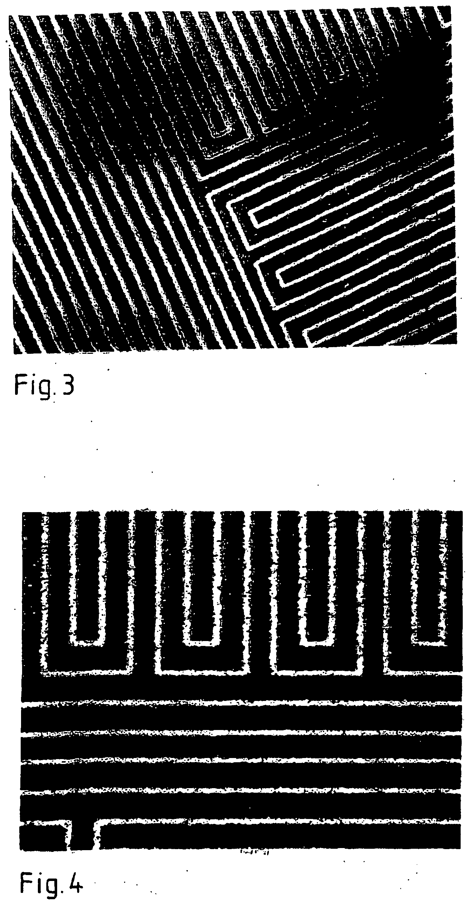

Fig. 3 zeigt ein laserstrukturiertes Kunststoffsubstrat nach der Behandlung mit einer Prozeßlösung gemäß Beispiel 2.
Fig. 4 zeigt eine mikroskopische Aufnahme der Oberflächenstruktur eines laserstrukturierten Kunststoffsubstrates nach der Behandlung gemäß Beispiel 3.

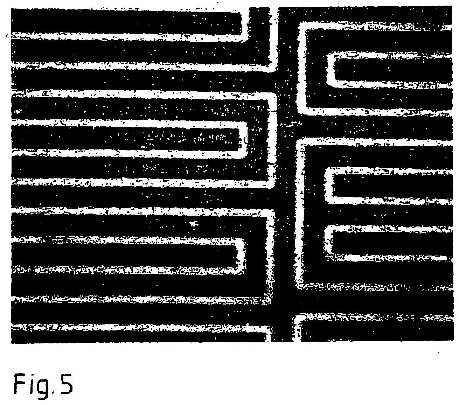

Fig. 5 zeigt die mikroskopische Aufnahme der Oberflächenstruktur eines laserstrukturierten Kunststoffsubstrates nach der Behandlung gemäß Beispiel 4.

## Patentansprüche

1. Verfahren zur Behandlung von mittels Laser zur Erzeugung von zur anschließenden Metallisierung geeigneten Keimstrukturen auf der Oberfläche strukturierten Kunststoffsubstraten, **dadurch gekennzeichnet, dass** die Substrate nach der Laserstrukturierung zur Entfernung der während der Laserstrukturierung entstandenen ungewollten Metallkeimablagerungen mit einer Prozesslösung in Kontakt gebracht werden, welche eine Mischung aus Netzmitteln und die Reinigung unterstützenden Stoffen aufweist, wobei als die Reinigung unterstützende Stoffe saure, neutrale oder alkalische Substanzen eingesetzt werden, **dadurch gekennzeichnet, dass** als saure Substanz Phosphorsäure, Schwefelsäure, Salzsäure, Methansulfonsäure, Citronensäure, Bernsteinsäure, Adipinsäure, Amidoschwefelsäure, Malonsäure, Methansäure, Ethansäure, Propansäure, n-Butansäure, n-Pentansäure, n-Hexansäure, Oxalsäure, Natriumhydrogensulfat, Kaliumhydrogensulfat, Borfluorwasserstoffsäure oder eine Mischung dieser; als neutrale Substanz Kaliumsulfat, Natriumsulfat; und als alkalische Substanz Natriumhydroxid, Natriumcarbonat, Pentanatriumtriphosphat, Tetranatriumdiphosphat, Natriumgluconat, Natriummetasilikat, Natriumhydrogencarbonat, Trinatriumcitrat, Tetranatriumpyrophosphat, Natriumtripolyphosphat und entsprechende Kaliumsalze oder eine Mischung dieser eingesetzt werden, und wobei saure, neutrale oder alkalische Substanz in einer Konzentration zwischen 0,1 mol/L und 2 mol/L anwesend sind.

2. Verfahren gemäß einem der vorhergehenden Ansprüche, **dadurch gekennzeichnet, dass** zur Unterstützung der Entfernung die laserstrukturierten Substrate während des Inkontaktbringens mit der Prozessflüssigkeit einem Ultraschallfeld ausgesetzt werden.

3. Verfahren gemäß einem der vorhergehenden Ansprüche, **dadurch gekennzeichnet, dass** als Netzmittel mindestens ein Netzmittel der Gruppe bestehend aus Ölsäureethoxylat, Fettalkoholethoxylat, Alkylphenolethoxylat, saurer Phosphorsäureester, Alkylphenolethersulfat und deren Natrium-Salz, Fettsäurekondensationsprodukt und deren Natrium-Salz, Alkylbenzolsulfonat, Alkanolaminsalz, Alkansulfonat und deren Natrium-Salz, Fettaminethoxylat, Fettalkoholalkoxylat, Propylenoxid-Ethylenoxid-Blockpolymerisat, Ethylenoxid-Propylen-oxid-Blockpolymerisat, Dimethylfettalkylbenzylammoniumchlorid, Alkylpolyethylenglycolether, Alkylglucoside, Oxoalkohole, Kokosfettsäurediethanolamid, Ölsäurediethanolamid, Natriumlaurylsulfat, Natriumlaurylsulfosuccinat, lineare Alkylbenzolsulfonsäure, Alkylbenzolsulfonate, Alkansulfonate, Fettalkoholsulfate, Fettalkoholethersulfate, Olefinsulfonate, Estersulfonate, Alkylphosphate, Alkyletherphosphate, Fettalkoholethoxylate, Alkylphenolethoxylate, Fettaminethoxylate, Fettsäureethoxylate, Fettsäureesterethoxylate, sonstige Alkoxylate, Alkanolamide, Zuckertenside, Aminoxide, Fluortenside, Alkalisalze von Fettsäuren oder eine Mischung dieser eingesetzt wird.

4. Verfahren gemäß einem der vorhergehenden Ansprüche, **dadurch gekennzeichnet, dass** die laserstrukturierten Substrate nacheinander mit einer alkalischen und einer sauren Prozesslösung oder umgekehrt in Kontakt gebracht werden.

5. Verfahren nach einem der Ansprüche 1 bis 3, **dadurch gekennzeichnet, dass** die laserstrukturierten Substrate ausschließlich mit neutralen Prozesslösungen in Kontakt gebracht werden.

## Claims

1. A method for treating plastic substrates structured by means of a laser for the generation of seed structures on the surface that are suitable for subsequent metallization, **characterized in that** to remove unintentional metal seed deposits that arise during the laser structuring after laser structuring the substrates are brought into contact with a process solution comprising a mixture of wetting agents and substances that support the cleaning, wherein acidic, neutral or alkaline substances are used as substances that support the cleaning **characterized in that** phosphoric acid, sulfuric acid, hydrochloric acid, methanesulfonic acid, citric acid, succinic acid, adipic acid, amidosulfuric acid, malonic acid, methanoic acid, ethanoic acid, propanoic acid, n-butanoic acid, n-pentanoic acid, n-hexanoic acid, oxalic acid, sodium hydrogen sulfate, potassium hydrogen sulfate, borofluoric acid or a mixture of these is used as acidic substance; as neutral substances potassium sulfate, sodium sulfate; and as alkaline substances sodium hydroxide, sodium carbonate, pentasodium triphosphate, tetrasodium diphosphate, sodium gluconate, sodium metasilicate, sodium hydrogen carbonate, trisodium citrate, tetrasodium pyrophosphate, sodium tripolyphosphate and the corresponding potassium salts or a mixture of these, and wherein the acidic, neutral or alkaline substanzes are present in a concentration of between 0.1 mol/L and 2 mol/L.

2. A method as in one of the preceding claims, which is **characterized by** the fact that to support the removal the laser-structured substrates are subjected to an ultrasound field while they are being brought into contact with the process liquid.

3. A method as in one of the preceding claims, which is **characterized by** the fact that at least one wetting agent from the group consisting of oleyl ethoxylate, fatty alcohol ethoxylate, alkylphenol ethoxylate, phosphoric acid ester, alkylphenol ether sulfate and their sodium salts, fatty acid condensation products and their sodium salts, alkylbenzene sulfonate, alkanolamine salt, alkane sulfonate and its sodium salt, fatty amine ethoxylate, fatty alcohol alkoxylate, propylene oxide-ethylene oxide block polymer, ethylene oxide-propylene oxide block polymer, dimethyl fatty alkylbenzylammonium chloride, alkyl polyethylene glycol ether, alkyl glucosides, oxo alcohols, coco fatty acid diethanolamide, oleic acid diethanolamide, sodium lauryl sulfate, sodium lauryl sulfosuccinate, linear alkylbenzenesulfonic acid, alkylbenzene sulfonates, alkane sulfonates, fatty alcohol sulfates, fatty alcohol ether sulfates, olefin sulfonates, ester sulfonates, alkyl phosphates, alkyl ether phosphates, fatty alcohol ethoxylates, alkyl phenol ethoxylates, fatty amine ethoxylates, fatty acid ethoxylates, fatty acid ester ethoxylates, other alkoxylates, alkanolamides, sugar surfactants, amine oxides, fluorine surfactants, alkali salts of fatty acids or a mixture of these is used as wetting agent.

4. A method as in one of the preceding claims, which is **characterized by** the fact that the laser-structured substrates are brought into contact successively with an alkaline process solution and an acidic process solution or vice versa.

5. A method as in one of claims 1 to 3, which is **characterized by** the fact that the laser-structured substrates are brought into contact exclusively with neutral process solutions.

## Revendications

1. Procédé de traitement au moyen d'un laser pour la création de structures de semences appropriées à la métallisation ultérieure sur la surface de substrats en matière plastique structurés, **caractérisé en ce que** les substrats, après la structuration au laser pour l'enlèvement de dépôts de semences métalliques non souhaités pendant la structuration au laser, sont mis en contact avec une solution de traitement, laquelle présente un mélange d'agents mouillants et des substances favorisant le nettoyage, où des substances acides, neutres ou alcalines sont employées en tant que substances favorisant le nettoyage, **caractérisé en ce qu'**en tant que substance acide, de l'acide phosphorique, de l'acide sulfurique, de l'acide chlorhydrique, de l'acide méthane sulfonique, de l'acide citrique, de l'acide succinique, de l'acide adipique, de l'acide amidosulfurique, de l'acide malonique, de l'acide méthanoïque, de l'acide éthanoïque, de l'acide propanoïque, de l'acide n-butanoïque, de l'acide n-pentanoïque, de l'acide n-hexanoïque, de l'acide oxalique, de l'hydrogéno-sulfate de sodium, de l'hydrogéno-sulfate de potassium, de l'acide borofluorhydrique ou un mélange de ceux-ci, sont employés ; en tant que substance neutre, du sulfate de potassium, du sulfate de sodium sont employés ; et tant que substance alcaline, de l'hydroxyde de sodium, du carbonate de sodium, du triphosphate de penta sodium, du di phosphate de tétra sodium, du gluconate de sodium, du méta silicate de sodium, de l'hydrogénocarbonate de sodium, du citrate de tri sodium, du pyrophosphate de tétra sodium, du tri polyphosphate de sodium et des sels de potassium correspondants ou un mélange de ceux-ci sont employés, et où les substances acide, neutre ou alcaline sont présentent à une concentration entre 0,1 mol/l et 2 mol/l.

2. Procédé selon l'une des revendications précédentes, **caractérisé en ce que**, pour la favorisation de l'enlèvement des substrats structurés au laser pendant la mise en contact avec le liquide de traitement, on emploie un champ d'ultrasons.

3. Procédé selon l'une des revendications précédentes, **caractérisé en ce qu'**en tant qu'agent mouillant, au moins un agent mouillant du groupe constitué d'éthoxylates d'acide gras, d'éthoxylates d'alcool gras, d'éthoxylates d'alkyl phénol, d'esters acides d'acide phosphorique, d'éther sulfates d'alkyl phénol et leurs sels de sodium, de produits de condensation d'acide gras et leurs sels de sodium, de sulfonates d'alkyl benzène, de sels d'alcanolamine, de sulfonates d'alcanes et leurs sels de sodium, d'éthoxylates d'amine grasse, d'alcoxylates d'alcool gras, de polymérisats séquencés d'oxyde de propylène - oxyde d'éthylène, de polymérisats séquencés oxyde d'éthylène - oxyde de propylène, de chlorures de benzalkonium d'acides gras alkyle diméthylé, de polyéthylène glycol éther d'alkyle, de glucosides d'alkyle, d'alcools oxo, de diéthanolamides d'acide gras de coco, de diéthanolamides d'acides gras, de laurylsulfate de sodium, de laurylsulfosuccinate de sodium, d'acides alkyl benzène sulfoniques linéaires, d'alkyl benzène sulfonates, d'alcane sulfonates, de sulfates d'alcool gras, d'éther sulfates d'alcool gras, de sulfonates d'oléfine, d'ester sulfonates, de phosphates d'alkyle, d'éther phosphates d'alkyle, d'éthoxylates d'alcool gras, d'éthoxylates d'alkyl phénol, d'éthoxylates d'amine grasse, d'éthoxylates d'acide gras, d'ester éthoxylates d'acide gras, d'autres alcoxylates, alcanolamides, d'amine oxydes, de tensioactifs fluorés, de sels alcalin d'acides gras ou d'un mélange de ceux-ci.

4. Procédé selon l'une des revendications précédentes, **caractérisé en ce que** les substrats structurés au laser sont mis en contact successivement avec une solution de traitement alcaline, puis une solution de traitement acide, ou dans le sens inverse.

5. Procédé selon l'une des revendications 1 à 3, **caractérisé en ce que** les substrats structurés au laser sont mis en contact exclusivement avec une solution de traitement neutre.
